# EUROPEAN PATENT APPLICATION

(11) **EP 3 657 536 A1**
(43) Date of publication of application: **27.05.2020**
(21) Application number: 17922019.9
(22) Date of filing: 14.09.2017
(51) Int. Cl.: H01L 21/67, H01L 21/02, H01L 21/677

(54) **WAFER EDGE POLISHING UNIT, AND APPARATUS AND METHOD FOR POLISHING WAFER EDGE COMPRISING SAME**

(30) Priority: 18.08.2017 KR 20170104728
(71) Applicant: SK Siltron Co., Ltd., Gumi-si, Gyeongsangbuk-do 39386 (KR)
(72) Inventor: JANG, Jun Young, Gumi-si Gyeongsangbuk-do 39400 (KR)
(74) Representative: Beder, Jens
(86) International application number: PCT/KR2017/010074
(87) International publication number: WO 2019/035507

(57) **Abstract**

An embodiment provides a wafer edge polishing unit comprising: a process chamber; a polishing stage which is arranged in a lower region of the process chamber and on which a wafer is arranged; a polishing unit, arranged at an edge of the polishing stage, for polishing the wafer; a slurry storage unit arranged in an upper region of the process chamber; a slurry supply unit for supplying a slurry to the slurry storage unit; a pure water supply unit for supplying pure water to an upper region of the polishing stage; a first pipe for supplying the slurry from the slurry storage unit to the polishing stage; a turbidity detection unit for detecting the turbidity of the slurry inside the first pipe; a second pipe for recovering the slurry from the polishing stage to the slurry storage unit; and a control unit for adjusting the amount of the slurry supplied from the slurry supply unit to the slurry storage unit according to the detected turbidity.

## Description

### [Technical Field]

Embodiments relate to polishing of the edge of a wafer, and more particularly to an apparatus and method for improving the polish of the edge of a wafer by maintaining the characteristics of slurry during polishing of the edge of the wafer.

### [Background Art]

A silicon wafer manufacturing process includes a single crystal growth process for producing a single-crystal ingot, a slicing process for slicing the single-crystal ingot to obtain a thin disk-shaped wafer, a grinding process for processing the outer periphery of the wafer obtained through the slicing process in order to prevent cracking or distortion of the wafer, a lapping process for removing remaining damage to the wafer due to mechanical processing, a polishing process for mirror-polishing the wafer, and a cleaning process for removing an abrasive or foreign substances from the polished wafer.

A wafer formed by slicing a single-crystal silicon ingot grown through the Czochralski method or the like may have an external appearance imparted thereto through grinding and lapping processes. The grinding and lapping may include grinding and lapping processes that are performed on the edge of a wafer. During these processes, the edge of the wafer, as well as two opposite surfaces of the wafer, may be damaged. Damage to the edge of the wafer may be removed through an edge-polishing process using a polishing pad.

The edge of the wafer may be polished by supplying slurry, in which an abrasive and a chemical are mixed, and de-ionized water (hereinafter, referred to as 'DIW') on the surface of the polishing pad and processing the edge of the wafer to have a rounded shape using friction with the polishing pad.

In this case, the slurry used to polish the edge of the wafer may be recycled and used without being drained to the outside.

However, the conventional wafer edge polishing described above has the following problems.

When the edge of the wafer is polished, the recycled slurry is included, and thus the composition of the slurry changes. Therefore, when the edge of the wafer is polished by the slurry including the recycled slurry, polishing characteristics may be deteriorated.

Further, if the time point at which the characteristics of the slurry are deteriorated due to the recycled slurry is not immediately recognized, there occurs a problem in that the characteristics of the wafer are continuously deteriorated. Therefore, it is required to recognize the time point at which the characteristics of the slurry are deteriorated.

### [Disclosure]

### [Technical Problem]

Embodiments provide a wafer edge polishing apparatus and method for maintaining constant characteristics of slurry during a wafer edge polishing process or the like.

### [Technical Solution]

An embodiment provides a wafer edge polishing unit including: a process chamber; a polishing stage disposed at a lower region in the process chamber such that a wafer is disposed thereon; a polishing unit disposed on a peripheral portion of the polishing stage to polish the wafer; a slurry storage unit disposed at an upper region in the process chamber; a slurry supply unit configured to supply slurry to the slurry storage unit; a de-ionized water supply unit configured to supply de-ionized water to an upper region of the polishing stage; a first pipe configured to supply the slurry to the polishing stage from the slurry storage unit; a turbidity detection unit configured to detect a turbidity of the slurry in the first pipe; a second pipe configured to collect the slurry from the polishing stage to the slurry storage unit; and a controller configured to adjust the amount of slurry to be supplied from the slurry supply unit to the slurry storage unit according to the detected turbidity.

The turbidity detection unit may include a light emitter disposed adjacent to one side surface of the first pipe, a light receiver disposed adjacent to another side surface that is opposite the one side surface of the first pipe, and a feedback unit configured to transmit the turbidity measured by the light receiver to the controller.

The optical axis of the light that is emitted from the light emitter and travels to the light receiver may intersect the direction in which the first pipe is disposed.

The first pipe may be formed of a light-transmissive material, and may be disposed between the light emitter and the light receiver.

The first pipe may include a first portion disposed adjacent to the slurry storage unit, a third portion disposed adjacent to the polishing stage, and a second portion disposed between the first portion and the third portion, and the second portion may be formed of a light-transmissive material.

Two opposite ends of the second portion may be inserted into the first portion and the third portion, respectively.

The two opposite ends of the second portion may have a male thread shape, and the regions of the first potion and the third portion into which the second portion is inserted may have a female thread shape.

The wafer edge polishing unit may further include a drain unit provided below the polishing stage to drain the slurry and the de-ionized water.

The wafer edge polishing unit may further include at least one of a temperature measuring unit configured to measure the temperature in the slurry storage unit or a pH measuring unit configured to measure the pH in the slurry storage unit.

The humidity in the process chamber may range from 35% to 85%.

The temperature in the process chamber may range from 20 degrees Celsius below zero to 55 degrees Celsius above zero.

The feedback unit may transmit a slurry replacement signal to the controller within 250 microseconds according to the detected turbidity.

The slurry may include silica, KOH, NaOH, and a dispersant.

Another embodiment provides a wafer edge polishing apparatus including a chamber; a loading unit configured to load a plurality of wafers in the chamber; a notch processing unit configured to process notches of the plurality of wafers; a conveyance unit configured to convey the plurality of wafers having processed notches; the above-described edge polishing unit configured to process the edges of the plurality of conveyed wafers; and an unloading unit configured to unload the plurality of wafers having polished edges.

A further embodiment provides a wafer edge polishing method including polishing the edge of a wafer while supplying slurry and de-ionized water to a polishing stage; detecting the turbidity of the slurry while collecting the slurry from the polishing stage; and when the turbidity of the collected slurry is equal to or less than a predetermined value, resupplying a mixture of the collected slurry and new slurry to the polishing stage.

The wafer edge polishing method may further include, when the turbidity of the collected slurry is less than the predetermined value, resupplying the collected slurry to the polishing stage.

When the volume of the collected slurry is less than a predetermined value, new slurry may be supplied.

### [Advantageous Effects]

According to the wafer edge polishing unit and the wafer edge polishing apparatus and method including the same according to the embodiment, the turbidity of slurry that is collected and recycled during polishing of a wafer is detected, and thus when the proportion by weight of silica in the slurry decreases, all of the slurry that has been collected and is being reused is drained, and only new slurry liquid is supplied and used, or new slurry liquid is additionally supplied to the slurry that is being reused, thereby preventing deterioration in the polishing characteristics at the edge of the wafer.

### [Description of Drawings]

FIG. 1 is a diagram showing the configuration of a wafer edge polishing apparatus according to an embodiment,
FIG. 2 is a diagram showing the configuration of the wafer edge polishing unit in FIG. 1,
FIG. 3 is a diagram showing the configuration of the turbidity detection unit in FIG. 2,
FIG. 4 is a view showing the configuration of the first pipe in FIG. 3,
FIG. 5 is a diagram showing the operation of the wafer edge polishing unit in FIG. 2,
FIG. 6 is a diagram showing a wafer edge polishing method according to an embodiment,
FIG. 7A is a diagram showing a change in the amount of slurry in the slurry storage unit during polishing of the edge of the wafer according to a comparative example,
FIG. 7B is a diagram showing a change in the characteristics of slurry in the slurry storage unit during polishing of the edge of the wafer according to the comparative example, and
FIG. 7C is a diagram showing a change in the characteristics of slurry in the slurry storage unit during polishing of the edge of the wafer according to the embodiment.

### [Best Mode]

Reference will now be made in detail to embodiments, examples of which are illustrated in the accompanying drawings.

However, the present disclosure may be embodied in many different forms, and should not be construed as being limited to the embodiments set forth herein. Rather, these embodiments are provided so that this disclosure will be thorough and complete and will fully convey the scope of the disclosure to those skilled in the art.

In addition, relational terms, such as "first", "second", "on", and "under", are used only to distinguish between one subject or element and another subject and element without necessarily requiring or involving any physical or logical relationship or sequence between such subjects or elements.

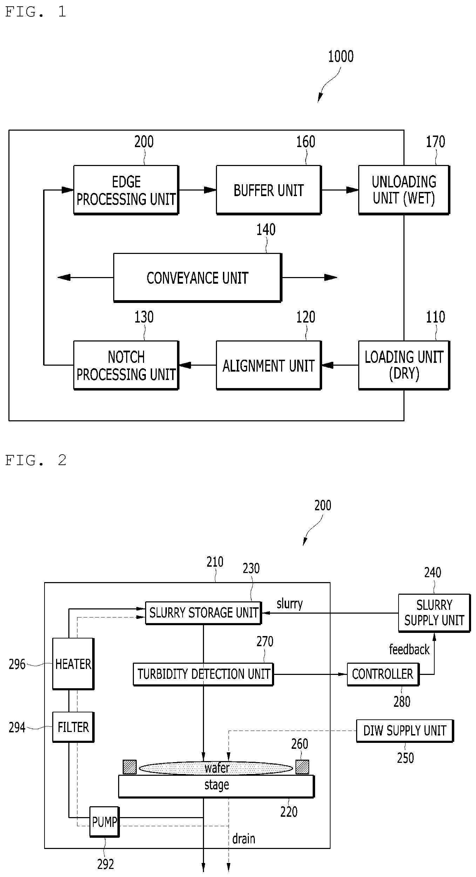

FIG. 1 is a diagram showing the configuration of a wafer edge polishing apparatus according to an embodiment.

A wafer edge polishing apparatus 1000 according to the embodiment includes, in a chamber, a loading unit 110, an alignment unit 120, a notch processing unit 130, a conveyance unit 140, an edge processing unit 200, a buffer unit 160, and an unloading unit 170.

The chamber may partition the space in which the above-described components are provided, and the interior of the chamber may not be shielded from the outside.

The loading unit 110 may introduce a silicon wafer into the chamber from the outside. A plurality of wafers to be introduced may be provided in a cassette, and may be introduced in a dry state.

The alignment unit 120 may align each wafer introduced into the chamber from the cassette so that notch processing or edge processing, which will be described later, may be performed.

The notch processing unit 130 may process a notch portion of the wafer. The notch portion of the wafer may be formed by processing a portion of the wafer in a specific crystal orientation in order to orient the wafer in the manufacturing process.

The conveyance unit 140 may be located in the central region of the chamber, and may convey the wafer loaded in the chamber until the wafer is unloaded to the outside of the chamber after a processing process to be described later. In detail, the conveyance unit 140 may convey the wafer while moving from the loading unit 110 to the unloading unit 170 inside the chamber.

The conveyance unit 140 may convey the wafer having the processed notch toward the edge processing unit 200. The conveyance unit 140 may convey a plurality of wafers at the same time.

The edge polishing unit 200 may process the edge of the wafer conveyed after the notch processing.

FIG. 2 is a diagram showing the configuration of the wafer edge polishing unit in FIG. 1.

The wafer edge polishing unit 200 according to the embodiment may include a process chamber 210, a polishing stage 220, a slurry storage unit 230, a slurry supply unit 240, a DIW supply unit 250, a polishing unit 260, a turbidity detection unit 270, and a controller 280. In addition, a pump 292, a filter 294, and a heater 296 may be further included.

The process chamber 210 may partition the space in which the above-described components are provided, and the interior of the process chamber 210 may not be shielded from the outside. Further, the process chamber 210 may be the same as the chamber of the wafer edge polishing apparatus 1000 described above.

The humidity in the process chamber 210 may be maintained at, for example, 35% to 85%, and the temperature therein may be maintained at, for example, 20 degrees below zero to 55 degrees above zero. The temperature in the process chamber 210 may cool the frictional heat due to the polishing of the wafer, and the humidity may allow the edge of the wafer to be appropriately polished by friction between the pad and the wafer.

The polishing stage 220 may be disposed in the lower region of the process chamber 210, and the wafer may be disposed on the polishing stage 220.

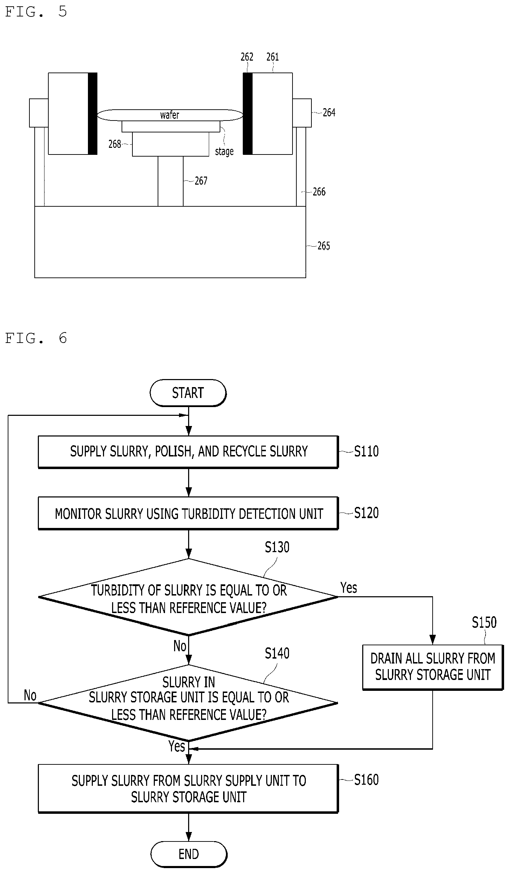

The polishing unit 260 may polish the wafer on the polishing stage 220. The polishing process will be described later with reference to FIG. 5.

The slurry storage unit 230 may be disposed above the polishing stage 220. The slurry storage unit 230 may receive slurry from the slurry supply unit 240 and store the same, and may then supply the slurry toward the wafer during polishing of the wafer.

The slurry may include silica, KOH, NaOH, and a dispersant. The silica may be distributed relatively uniformly in the slurry by the action of the dispersant. When polishing by the slurry and collection of the slurry are repeated, DIW may be mixed in the slurry, and a portion of the silica is discharged, whereby the proportion by weight (wt%) of the silica in the slurry may decrease.

The slurry supply unit 240 may supply the slurry to the slurry storage unit 230 in the process chamber 210. However, the slurry supply unit 240 may not necessarily be provided outside the process chamber 210.

Newly produced slurry is provided in the slurry supply unit 240, and the slurry storage unit 230 is distinguished in that slurry recycled after the polishing process may also be included therein.

The DIW supply unit 250 may be disposed outside the process chamber 210, and may supply DIW toward the polishing stage 220 during the wafer polishing process. However, the DIW supply unit 250 may not necessarily be provided outside the process chamber 210.

The slurry may be supplied from the slurry storage unit 230 toward the polishing stage 220 in the direction indicated by the solid line. A first pipe may be provided, and the slurry maybe supplied into the first pipe.

The slurry and the DIW used for polishing may be collected toward the slurry storage unit 230, and may be recycled.

In FIG. 2, the directions in which the slurry and the DIW are collected are indicated by the solid line and the dotted line, respectively, in the left region inside the process chamber 210. In this case, a second pipe may be provided, and the slurry and the DIW may be collected into the second pipe.

The slurry may be supplied during processing of the wafer, and the DIW may be supplied during cleaning of the processing apparatus and the stage. The slurry and the DIW may be drained to the bottom of the process chamber 210. In detail, a portion of the slurry may be drained during supply of the DIW described above.

In addition, when the slurry and the DIW are collected through the pump 292, the waste generated by polishing the wafer may also be collected. Therefore, the filter 294 may be provided in the second pipe in order to prevent unnecessary polishing byproducts, other than the slurry and the DIW, from being collected toward the slurry storage unit 230. In addition, the slurry and the DIW, having passed through the filter, may be collected again to the slurry storage unit 230 via the heater 296.

Although not illustrated, a drain unit may be provided below the polishing stage in order to drain the slurry and the DIW used to polish the wafer.

FIG. 5 is a diagram showing the operation of the wafer edge polishing unit in FIG. 2.

The polishing unit 260 may include a body 265, a chuck shaft 267 located on the body 265, a lower plate 268 located on the chuck shaft 267, a pad 262 configured to polish the edge region of the wafer, a pad holder 261, a pad holder support part 264, and a connecting part 266.

The body 265 may support the chuck shaft 267 and the pad holder support part 264. The chuck shaft 267 may rotate in a constant direction and may be connected to the lower plate 268 located thereon.

The lower plate 268 may be rotated by the chuck shaft 267 and may support the polishing stage. The polishing stage may be located on the lower plate 268 and may rotate in conjunction with rotation of the lower plate 268.

A wafer to be polished may be provided on the polishing stage. The wafer may be mounted on the polishing stage via adsorption. For example, the bottom surface of the polishing stage may be in contact with the lower plate 268, and the front surface of the wafer may be in contact with the top surface of the polishing stage.

The pad 262 may be disposed around the outer circumferential surface of the polishing stage, and may polish the edge portion, adjacent to the front surface of the wafer mounted on the polishing stage.

The pad holder 261 may fix the pad 262, and the pad holder support part 264 may support the pad holder 261 and may move upwards and downwards. In addition, the pad holder support part 264 maybe moved upwards and downwards by the connecting part 266, which is connected to the body 265.

The turbidity detection unit 270 may detect the turbidity of the slurry supplied from the slurry storage unit 230 toward the polishing stage through the first pipe described above. In addition, the controller 280 may supply new slurry from the slurry supply unit 240 to the slurry storage unit 230 according to the detected turbidity of the slurry, and at this time, may discharge the existing slurry from the slurry storage unit 230.

The wafer polishing characteristics are strongly related to the proportion by weight of silica in the slurry. Specifically, when the proportion by weight of silica decreases, the wafer polishing characteristics may be degraded. The turbidity detection unit 270 may determine the replacement period of the slurry based on the turbidity of the slurry in consideration of the property whereby the slurry becomes increasingly transparent as the proportion by weight of the silica in the slurry decreases.

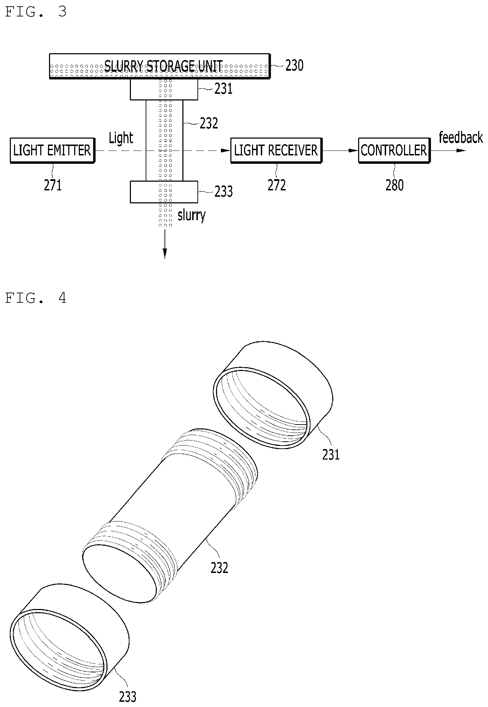

FIG. 3 is a diagram showing the configuration of the turbidity detection unit in FIG. 2.

The turbidity detection unit 270 may be located in a path along which the slurry falls from the slurry storage unit 230 toward the wafer.

The turbidity detection unit 270 may include a light emitter 2710 and a light receiver 272. In addition, the first pipe for supplying the slurry from the slurry storage unit 230 may include a first portion 231, a second portion 232, and a third portion 233.

The light emitter 271 may be disposed on one side surface of the second portion 232 of the first pipe, and may emit light. For example, the light emitter 271 may be a light emitting device such as a light emitting diode.

The light receiver 272 may be disposed adjacent to the opposite side surface of the second portion 232 of the first pipe, and maybe a photodetector, e.g. a photodiode, which becomes capable of measuring the energy of photons absorbed therein.

As illustrated, the light emitter 271 and the light receiver 272 may be disposed opposite each other, with the second portion 232 of the first pipe interposed therebetween, such that the light emitted from the light emitter 271 passes through the second portion 232 of the first pipe and is detected by the light receiver 272.

In addition, the turbidity detection unit 270 may further include a feedback unit (not shown), which transmits the turbidity measured by the light receiver 272 to the controller 280. In this case, the feedback unit may quickly transmit a slurry replacement signal to the controller 280 according to the detected turbidity, e.g. within 250 microseconds.

In this case, the turbidity is measured by the light receiver 272 based on the principle whereby the light emitter 271 emits light having a constant intensity but the intensity of the light incident on the light receiver 272 after passing through the second portion 232 of the first pipe changes depending on the turbidity of the slurry.

The components of the wafer edge polishing unit 200 may endure vibration having a double amplitude of 1.5 millimeters that is applied with a frequency of 10 to 55 Hz in the x-axis direction, the y-axis direction, and the z-axis direction for two hours.

In FIG. 3, the optical axis of the light that is emitted from the light emitter 271 and travels to the light receiver 272 may be disposed so as to intersect the direction in which the second portion 232 of the first pipe is disposed. Further, the direction in which the second portion 232 of the first pipe is disposed may be a vertically downward direction. Here, the optical axis is the path of the light emitted from the light emitter.

When the aforementioned optical axis is disposed so as to approximately perpendicularly intersect the direction in which the second portion 232 is disposed, rather than being disposed at an incline with respect to the direction in which the second portion 232 is disposed, it is possible to more accurately measure the turbidity of the slurry that passes through the second portion 232. If the optical axis and the direction in which the second portion 232 is disposed are inclined at an acute angle relative to each other, rather than being disposed so as to be approximately perpendicular to each other, the slurry may accumulate on the inner wall of the second portion 232.

The first pipe, particularly the second portion 232 thereof, may be made of a light-transmissive material, such as light-transmissive PVC.

FIG. 4 is a view showing the configuration of the first pipe in FIG. 3.

Two opposite ends of the second portion 232 may be inserted into the first portion 231 and the third portion 233, respectively. In detail, the two opposite ends of the second portion 232 may have a male thread shape, and the regions of the first portion 231 and the third portion 233 into which the second portion 232 is inserted may have a female thread shape.

Thus, the second portion 232 may be separated from the first portion 231 and the third portion 233. For example, the case where the intensity of the light incident on the above-described light receiver 272 is too small may correspond to the case in which the transparency of the second portion 232 has decreased due to adhesion of the slurry to the inner wall of the second portion 232. In this case, foreign substances in the old slurry may be supplied toward the polishing stage 220. Therefore, only the second portion 232 may be separated and replaced.

Although not illustrated, the wafer edge polishing unit 200 may be provided with a temperature measuring unit and a pH measuring unit for measuring the temperature and the pH of the slurry in the slurry storage unit 230, respectively.

If the temperature and the pH of the slurry measured by the temperature measuring unit and the pH measuring unit described above are out of predetermined ranges, it may affect polishing of the edge of the wafer. Therefore, when the temperature of the slurry becomes too high due to heat generated during polishing of the edge of the wafer, cooling water may be injected. Further, when the pH of the slurry is out of a predetermined range, the slurry in the slurry storage unit 230 may be drained, and new slurry may be supplied from the slurry supply unit 240 to the slurry storage unit 230.

The turbidity detection unit and the controller described above may be used not only in the wafer edge polishing unit but also in the notch processing unit, and may also be used in other types of apparatuses for processing a wafer using slurry or the like so as to recognize the state of the slurry and replace the same through the actions thereof.

FIG. 6 is a diagram showing a wafer edge polishing method according to an embodiment. The wafer edge polishing method according to this embodiment may be a method using the above-described wafer edge polishing apparatus.

First, the edge of the wafer may be processed into a rounded shape by polishing the edge of wafer while supplying slurry to the polishing stage. In this case, DIW may be supplied together with the slurry, and a portion of the slurry used for polishing may be collected. When the slurry is collected, the DIW and polishing byproducts may be collected together therewith. However, the polishing byproducts are filtered by a filtration action of the filter or the like (S110).

Then, the turbidity detection unit monitors the slurry (S120). Monitoring of the slurry means measuring of the turbidity of the slurry, and may be performed by the actions of the light receiver and the light emitter, as described above. When the proportion by weight of silica in the slurry decreases, the measured turbidity of the slurry may be smaller, and when the proportion by weight of silica increases, the measured turbidity of the slurry may be larger. Here, the case in which the turbidity is large and the case in which the turbidity is small may be opposite the units shown in Tables 1 and 2, which will be described later.

Then, the measured turbidity of the slurry is compared with a reference value (S130). When the measured turbidity of the slurry is equal to or less than the reference value (Yes), it may be estimated that the proportion by weight of silica in the slurry is equal to or less than a predetermined value. When the proportion by weight of silica in the slurry decreases, the edge of the wafer may not be polished normally, and thus the slurry may need to be replaced.

Therefore, replacement of the slurry may be required, and all of the slurry in the slurry storage unit may be drained (S150).

Then, new slurry liquid may be supplied from the slurry supply unit to the slurry storage unit (S160).

When the turbidity measured by the turbidity detection unit is less than the reference value (No), it may be estimated that the proportion by weight of silica in the slurry is larger than the predetermined value. Therefore, since the proportion by weight of silica in the slurry is large enough to effectively polish the edge of the wafer, the slurry may not need to be replaced.

In this case, the amount of slurry in the slurry storage unit is measured in order to determine whether it is equal to or less than a reference value (S140). Specifically, the height of the slurry stored in the slurry storage unit may be measured.

When the height of the slurry in the slurry storage unit is equal to or less than the reference value, the amount of slurry may be insufficient to polish the wafer, and thus new slurry liquid may be supplied from the slurry supply unit to the slurry storage unit (S160).

When the height of the slurry in the slurry storage unit exceeds the reference value, it can be considered that sufficient slurry is present to polish the wafer, and thus supply of the slurry and polishing of the edge of the wafer may be continuously performed (S110).

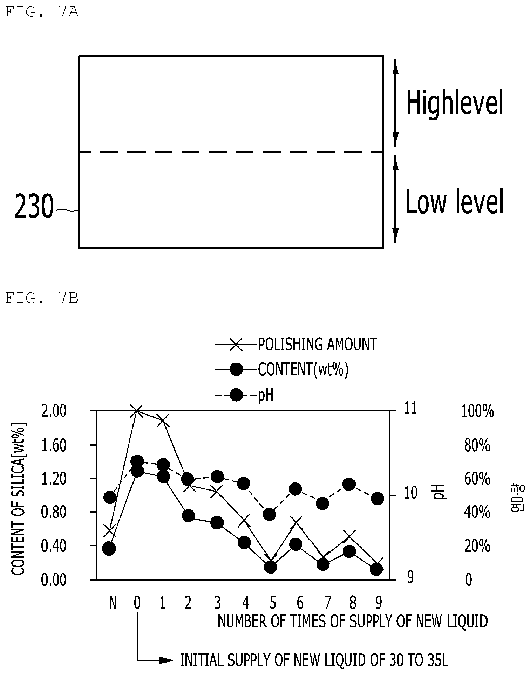

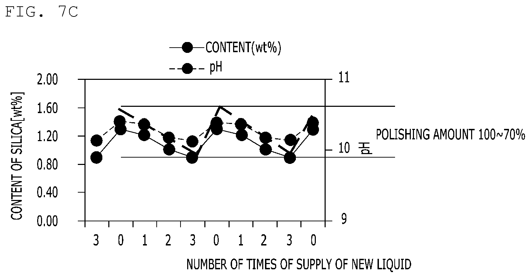

FIG. 7A is a diagram showing a change in the amount of slurry in the slurry storage unit during polishing of the edge of the wafer according to a comparative example, FIG. 7B is a diagram showing a change in the characteristics of slurry in the slurry storage unit during polishing of the edge of the wafer according to the comparative example, and FIG. 7C is a diagram showing a change in the characteristics of slurry in the slurry storage unit during polishing of the edge of the wafer according to the embodiment.

In FIG. 7A, when the amount of slurry in the slurry storage unit 230 reaches a low level, as described above, new slurry liquid is additionally supplied to the slurry storage unit so that the amount of the slurry reaches a high level.

In this case, as the number of times of collection and recycling of the slurry increases, the characteristics of the slurry in the slurry storage unit 230 may be deteriorated even when new slurry liquid is additionally supplied and mixed therewith.

As shown in FIG. 7B, as the number of times of supply of new slurry liquid increases, as indicated by the direction of the horizontal axis, the proportion by weight (wt%) of silica in the entire slurry in the slurry storage unit 230 gradually decreases, and although the pH does not greatly decrease, the polishing amount of the wafer decreases in a pattern similar to the decrease in the proportion by weight of silica.

Table 1 shows a change in the characteristics of the slurry in the slurry storage unit during polishing of the edge of the wafer according to the comparative example.

**[Table 1]**

| Number of Times of Supply of New Liquid | Turbidity | Proportion by Weight of Silica(wt%) | Polishing Amount (%) |
|---|---|---|---|
| 0 | 1219 | 1.3 | 100 |
| 1 | 1293 | 1.22 | 94 |
| 2 | 1757 | 0.72 | 55 |
| 3 | 1803 | 0.67 | 52 |
| 4 | 2007 | 0.45 | 35 |
| 5 | 2286 | 0.15 | 12 |
| 6 | 2026 | 0.43 | 33 |
| 7 | 2267 | 0.17 | 13 |
| 8 | 2128 | 0.32 | 28 |
| 9 | 2314 | 0.12 | 9 |

In the comparative example, as the number of times of supply of new liquid increases, the proportion by weight (wt%) of silica in the slurry may decrease. In this case, it can be seen that as the numerical value corresponding to the turbidity of the slurry gradually increases, the slurry becomes more transparent, and the turbidity decreases.

Table 2 shows a change in the characteristics of the slurry in the slurry storage unit during polishing of the edge of the wafer according to the embodiment.

**[Table 2]**

| Number of Times of Supply of New Liquid | Turbidity | Proportion by Weight of Silica (wt%) | Polishing Amount (%) |
|---|---|---|---|
| 3 | 1590 | 0.9 | 69 |
| 0 | 1219 | 1.3 | 100 |
| 1 | 1293 | 1.22 | 94 |
| 2 | 1497 | 1 | 77 |
| 3 | 1590 | 0.9 | 69 |
| 0 | 1219 | 1.3 | 100 |
| 1 | 1293 | 1.22 | 94 |
| 2 | 1497 | 1 | 77 |
| 3 | 1590 | 0.9 | 69 |
| 0 | 1219 | 1.3 | 100 |

In the embodiment, the number of times of supply of new liquid is the number of times that new slurry liquid is additionally mixed with the existing slurry. When the number of times of supply of new liquid is '0', this refers to the case in which all of the slurry in the slurry storage unit is drained and new slurry liquid is supplied to the slurry storage unit from the slurry supply unit such that the slurry storage unit is filled with the new slurry liquid. It can be seen that as the number of times of supply of new liquid increases, the proportion by weight (wt%) of silica in the slurry decreases and the polishing amount also decreases. As shown in Table 2, it can be seen that as the numerical value corresponding to the turbidity of the slurry gradually increases, the slurry becomes more transparent, and the turbidity decreases.

According to the wafer edge polishing unit and the wafer edge polishing apparatus and method including the same according to the embodiment, the turbidity of slurry that is collected and recycled during polishing of a wafer is detected, and thus when the proportion by weight of silica in the slurry decreases, all of the slurry that has been collected and is being reused is drained, and only new slurry liquid is supplied and used, thereby preventing deterioration in the polishing characteristics at the edge of the wafer.

Although the present disclosure has been described with reference to a limited number of embodiments and drawings, it is not limited to the above embodiments, and various modifications and changes can be made from the above description by those skilled in the art to which the present disclosure pertains.

Therefore, the scope of the present disclosure should not be construed as being limited to the description of the embodiments, but defined by the appended claims and equivalents thereof.

### [Industrial Applicability]

The apparatus and method according to the embodiment may improve polishing characteristics at the edge of a wafer.

## Claims

1. A wafer edge polishing unit comprising:
a process chamber;
a polishing stage disposed at a lower region in the process chamber such that a wafer is disposed thereon;
a polishing unit disposed on a peripheral portion of the polishing stage to polish the wafer;
a slurry storage unit disposed at an upper region in the process chamber;
a slurry supply unit configured to supply slurry to the slurry storage unit;
a de-ionized water supply unit configured to supply de-ionized water to an upper region of the polishing stage;
a first pipe configured to supply the slurry to the polishing stage from the slurry storage unit;
a turbidity detection unit configured to detect a turbidity of the slurry in the first pipe;
a second pipe configured to collect the slurry from the polishing stage to the slurry storage unit; and
a controller configured to adjust an amount of slurry to be supplied from the slurry supply unit to the slurry storage unit according to the detected turbidity.

2. The wafer edge polishing unit according to claim 1, wherein the turbidity detection unit comprises a light emitter disposed adjacent to one side surface of the first pipe, a light receiver disposed adjacent to another side surface that is opposite the one side surface of the first pipe, and a feedback unit configured to transmit a turbidity measured by the light receiver to the controller.

3. The wafer edge polishing unit according to claim 2, wherein an optical axis of light that is emitted from the light emitter and travels to the light receiver intersects a direction in which the first pipe is disposed.

4. The wafer edge polishing unit according to claim 2, wherein the first pipe is formed of a light-transmissive material and is disposed between the light emitter and the light receiver.

5. The wafer edge polishing unit according to claim 4, wherein the first pipe comprises a first portion disposed adjacent to the slurry storage unit, a third portion disposed adjacent to the polishing stage, and a second portion disposed between the first portion and the third portion, and
wherein the second portion is formed of a light-transmissive material.

6. The wafer edge polishing unit according to claim 5, wherein two opposite ends of the second portion are inserted into the first portion and the third portion, respectively.

7. The wafer edge polishing unit according to claim 6, wherein the two opposite ends of the second portion have a male thread shape, and regions of the first potion and the third portion into which the second portion is inserted have a female thread shape.

8. The wafer edge polishing unit according to claim 1, further comprising a drain unit provided below the polishing stage to drain the slurry and the de-ionized water.

9. The wafer edge polishing unit according to claim 1, further comprising at least one of a temperature measuring unit configured to measure a temperature in the slurry storage unit or a pH measuring unit configured to measure pH in the slurry storage unit.

10. The wafer edge polishing unit according to claim 1 or 2, wherein a humidity in the process chamber ranges from 35% to 85%.

11. The wafer edge polishing unit according to claim 1 or 2, wherein a temperature in the process chamber ranges from 20 degrees Celsius below zero to 55 degrees Celsius above zero.

12. The wafer edge polishing unit according to claim 2, wherein the feedback unit transmits a slurry replacement signal to the controller within 250 microseconds according to the detected turbidity.

13. The wafer edge polishing unit according to claim 1 or 2, wherein the slurry comprises silica, KOH, NaOH, and a dispersant.

14. A wafer edge polishing apparatus comprising:
a chamber;
a loading unit configured to load a plurality of wafers in the chamber;
a notch processing unit configured to process notches of the plurality of wafers;
a conveyance unit configured to convey the plurality of wafers having processed notches;
an edge polishing unit configured to process edges of the plurality of conveyed wafers; and
an unloading unit configured to unload the plurality of wafers having polished edges,
wherein the edge polishing unit comprises:
a process chamber;
a polishing stage disposed at a lower region in the process chamber such that a wafer is disposed thereon;
a polishing unit disposed on a peripheral portion of the polishing stage to polish the wafer;
a slurry storage unit disposed at an upper region in the process chamber;
a slurry supply unit configured to supply slurry to the slurry storage unit;
a de-ionized water supply unit configured to supply de-ionized water to an upper region of the polishing stage;
a first pipe configured to supply the slurry to the polishing stage from the slurry storage unit;
a turbidity detection unit configured to detect a turbidity of the slurry in the first pipe;
a second pipe configured to collect the slurry from the polishing stage to the slurry storage unit; and
a controller configured to adjust an amount of slurry to be supplied from the slurry supply unit to the slurry storage unit according to the detected turbidity.

15. The wafer edge polishing apparatus according to claim 14, wherein the turbidity detection unit comprises a light emitter disposed adjacent to one side surface of the first pipe, a light receiver disposed adjacent to another side surface that is opposite the one side surface of the first pipe, and a feedback unit configured to transmit a turbidity measured by the light receiver to the controller.

16. The wafer edge polishing apparatus according to claim 14, wherein the first pipe comprises a first portion disposed adjacent to the slurry storage unit, a third portion disposed adjacent to the polishing stage, and a second portion disposed between the first portion and the third portion, and
wherein the second portion is formed of a light-transmissive material.

17. The wafer edge polishing apparatus according to claim 16, wherein two opposite ends of the second portion are inserted into the first portion and the third portion, respectively, and have a male thread shape, and regions of the first potion and the third portion into which the second portion is inserted have a female thread shape.

18. A wafer edge polishing method comprising:
polishing an edge of a wafer while supplying slurry and de-ionized water to a polishing stage;
detecting a turbidity of the slurry while collecting the slurry from the polishing stage; and
when a turbidity of the collected slurry is equal to or less than a predetermined value, resupplying a mixture of the collected slurry and new slurry to the polishing stage.

19. The wafer edge polishing method according to claim 18, further comprising, when the turbidity of the collected slurry is less than the predetermined value, resupplying the collected slurry to the polishing stage.

20. The wafer edge polishing method according to claim 18 or 19, wherein, when a volume of the collected slurry is less than a predetermined value, new slurry is supplied.
